# EUROPEAN PATENT APPLICATION

(11) **EP 1 142 946 A1**
(43) Date of publication of application: **10.10.2001**
(21) Application number: 00302905.5
(22) Date of filing: 06.04.2000
(51) Int. Cl.: C08K 3/22, C08L 83/04

(54) **Curable silicone composition**

(71) Applicant: Dow Corning Toray Silicone Co., Ltd., Tokyo (JP)
(72) Inventor: Nakamura, Akihiro c/o Dow Corning Toray Sil. C.Ltd, Chiba Prefecture, (JP); Enami, Hiroji c/o Dow Corning Toray Sil. C.Ltd, Chiba Prefecture, (JP)
(74) Representative: Kyle, Diana

(57) **Abstract**

A curable silicone composition comprising
(A) organopolysiloxane comprising 80 to 96.5 mole% R¹₂SiO_{2/2} units, 1 to 10 mole% R¹SiO_{3/2} units, 0 to 6 mole% R¹₃SiO_{1/2} units, and 0.25 to 4 mole% R¹₂R²SiO_{1/2} units where R¹ is a monovalent hydrocarbon group free of aliphatic unsaturation and R² is an alkenyl group;
(B) diorganopolysiloxane having a viscosity at 25°C of from 1 to 100,000 mPa·s and containing on average at least 2 alkenyl groups in each molecule, in a quantity such that component (B) is from 10 to 90 weight% of the sum of components (A) and (B);
(C) organopolysiloxane having a viscosity at 25°C of from 1 to 100,000 mPa·s and containing on average at least 2 silicon-bonded hydrogen atoms in each molecule, in a quantity that provides a value of 0.7 to 1.5 for the molar ratio of silicon-bonded hydrogen in this component to alkenyl groups in the sum of components (A) and (B);
(D) a platinum hydrosilylation catalyst in a quantity that provides from 0.01 to 1,000 weight parts platinum metal per million parts of the sum of components (A), (B), and (C);
   and
(E) alumina powder at from 200 to 1,500 weight parts for each 100 weight parts of the sum of components (A) and (B).

## Description

This invention relates to a curable silicone composition. More particularly, this invention is a curable silicone composition that cures by a hydrosilylation reaction to give a cured silicone that exhibits excellent peelability to facilitate repair of components sealed therewith. Curable silicone compositions comprising alkenyl-functional branched organopolysiloxane, SiH-functional organopolysiloxane, and a platinum hydrosilylation catalyst and compositions of this type which also contain an inorganic filler such as silica powder as an optional component are taught in, for example, Japanese Laid Open (Kokai or Unexamined) Patent Application Numbers Sho 58-7452 (7,452/1983), Sho 62-181357 (181,357/1987), Sho 63-246856 (246,856/1988), Hei 5-70693 (70,693/1993), and Hei 10-212413 (212,413/1998).

These curable silicone compositions are used as sealants and potting materials for electrical and electronic components, such as computer chips, MPUs, and transistors (refer to Japanese Laid Open (Kokai or Unexamined) Patent Application Numbers Sho 63-246856 and Hei 10-212413). However, the low durometer silicone rubbers and silicone gels afforded by the cure of these compositions have a low strength and/or low elongation. As a consequence, when removal of such a rubber or gel is sought in order to repair or replace the electrical or electronic component, the rubber or gel will crack and fissure and cannot be cleanly peeled off, resulting in a poor repair behavior. It is an object of this invention to provide a curable silicone composition that cures by means of a hydrosilylation reaction to give a cured silicone that exhibits an excellent repair behavior.

The present invention is a curable silicone composition comprising
(A) organopolysiloxane comprising 80 to 96.5 mole% R¹₂SiO_{2/2} units, 1 to 10 mole% R¹SiO_{3/2} units, 0 to 6 mole% R¹₃SiO_{1/2} units, and 0.25 to 4 mole% R¹₂R²SiO_{1/2} units where R¹ is a monovalent hydrocarbon group free of aliphatic unsaturation and R² is an alkenyl group;
(B) diorganopolysiloxane having a viscosity at 25°C of from 1 to 100,000 mPa·s and containing on average at least 2 alkenyl groups in each molecule, in a quantity such that component (B) is from 10 to 90 weight% of the sum of components (A) and (B);
(C) organopolysiloxane having a viscosity at 25°C of from 1 to 100,000 mPa·s and containing on average at least 2 silicon-bonded hydrogen atoms in each molecule, in a quantity that provides a value of 0.7 to 1.5 for the molar ratio of silicon-bonded hydrogen in this component to alkenyl groups in the sum of components (A) and (B);
(D) a platinum hydrosilylation catalyst in a quantity that provides from 0.01 to 1,000 weight parts platinum metal per million parts of the sum of components (A), (B), and (C);
   and
(E) alumina powder at from 200 to 1,500 weight parts for each 100 weight parts of the sum of components (A) and (B).

The present invention is a curable silicone composition comprising
(A) organopolysiloxane comprising 80 to 96.5 mole% R¹₂SiO_{2/2} units, 1 to 10 mole% R¹SiO_{3/2} units, 0 to 6 mole% R¹₃SiO_{1/2} units, and 0.25 to 4 mole% R¹₂R²SiO_{1/2} units where R is a monovalent hydrocarbon group free of aliphatic unsaturation and R² is an alkenyl group;
(B) diorganopolysiloxane having a viscosity at 25°C of from 1 to 100,000 mPa·s and containing on average at least 2 alkenyl groups in each molecule, in a quantity such that component (B) is from 10 to 90 weight% of the sum of components (A) and (B);
(C) organopolysiloxane having a viscosity at 25°C of from 1 to 100,000 mPa·s and containing on average at least 2 silicon-bonded hydrogen atoms in each molecule, in a quantity that provides a value of 0.7 to 1.5 for the molar ratio of silicon-bonded hydrogen in this component to alkenyl groups in the sum of components (A) and (B);
(D) a platinum hydrosilylation catalyst in a quantity that provides from 0.01 to 1,000 weight parts platinum metal per million parts of the sum of components (A), (B), and (C);
   and
(E) alumina powder at from 200 to 1,500 weight parts for each 100 weight parts of the sum of components (A) and (B).

The curable silicone composition of this invention will be explained in greater detail in the following.

The organopolysiloxane (A) characteristically comprises R¹₂SiO_{2/2}, R¹SiO_{3/2}, and R¹₂R²SiO_{1/2} units and optionally R¹₃SiO_{1/2} units. R¹ in these units denotes monovalent hydrocarbon groups free of aliphatic unsaturation and can be exemplified by alkyl groups such as methyl, ethyl, and propyl; aryl groups such as phenyl, tolyl, and xylyl; aralkyl groups such as benzyl and phenethyl; and halogenated alkyl groups such as 3-chloropropyl and 3,3,3-trifluoropropyl. R² denotes alkenyl and can be exemplified by vinyl, allyl, butenyl, pentenyl, and hexenyl with vinyl being preferred.

This organopolysiloxane (A) should contain 80 to 96.5 mole% R¹₂SiO_{2/2} units, 1 to 10 mole% R¹SiO_{3/2} units, 0.25 to 4 mole% R¹₂R²SiO_{1/2} units, and optionally 0 to 6 mole% R¹₃SiO_{1/2} units. The use of organopolysiloxane in which the R¹SiO_{3/2} unit content is less than the lower limit of the above-specified range tends to give cured silicone with diminished physical properties, particularly in regards to strength. At the other extreme, organopolysiloxane in which R¹ SiO_{3/2} exceeds the upper limit of the above-specified range has a substantially increased viscosity, and the use of such organopolysiloxane tends to substantially impair the fluidity and handling characteristics of the resulting curable silicone composition.

The characteristic features of diorganopolysiloxane (B) are a viscosity at 25°C of 1 to 100,000 mPa·s and the presence of at least 2 alkenyl groups on average in each molecule. The alkenyl in (B) can be exemplified by the groups provided above as examples of R², with vinyl being particularly preferred. The non-alkenyl Si-bonded groups in (B) can be exemplified by the monovalent hydrocarbon groups provided above as examples of R¹, with methyl and phenyl being particularly preferred. Component (B) should have a substantially straight-chain molecular structure, although some portion of the molecular chain may be branched.

Component (B) should be present in the present composition in an amount of from 10 to 90 weight% of the sum of this component (B) with component (A). The physical properties of the cured silicone, and particularly the elongation, tend to be diminished when the component (B) content is less than the lower limit of the above-specified range. At the other extreme the physical properties of the cured silicone, particularly the tear strength, tend to be impaired when the component (B) content exceeds the upper limit of the specified range.

The organopolysiloxane (C) contains at least 2 silicon-bonded hydrogen atoms on average in each molecule and has a viscosity at 25°C of 1 to 100,000 mPa·s and preferably 1 to 5,000 mPa·s. The silicon-bonded groups in (C) can be exemplified by the monovalent hydrocarbon groups provided above as examples of R¹, with methyl and phenyl being particularly preferred. The molecular structure of (C) can be exemplified by straight chain, partially branched straight chain, branched chain, cyclic, and resinous.

The content of component (C) in the present composition should provide a value of 0.7 to 1.5 for the molar ratio of the silicon-bonded hydrogen in (C) to the sum of the alkenyl in component (A) and component (B). There is a tendency for the heat resistance of the ultimately obtained cured silicone to be impaired when the component (C) content is less than the lower limit of the above-specified range. At the other extreme, obtaining an acceptable cure from the curable silicone composition tends to be difficult when the component (C) content exceeds the upper limit of the specified range.

The platinum hydrosilylation catalyst (D) accelerates the hydrosilylation-mediated cure of the present composition. This catalyst is exemplified by chloroplatinic acid, alcohol solutions of chloroplatinic acid, olefin complexes of platinum, alkenylsiloxane complexes of platinum, and carbonyl complexes of platinum.

Component (D) should be present in the present composition in an amount that provides from 0.01 to 1,000 weight-ppm platinum metal and preferably from 0.1 to 500 weight-ppm platinum metal from this component, in each case calculated based on the sum of components (A), (B), and (C). Obtaining a rapid cure from the curable silicone composition tends to be difficult when the component (D) content is below the lower limit of the above-specified range, while there is very little improvement in the curing characteristics of the curable silicone composition at a component (D) content in excess of the upper limit of the specified range.

The alumina powder (E) functions to improve the repair behavior of the cured silicone. The particle size of (E) is not critical, but the average particle size is preferably ≤ 500 µm, more preferably ≤ 100 µm, and even more preferably ≤ 50 µm. The shape of component (E) is also not critical, and this component can have, for example, a spherical, plate-like, or irregular shape.

The component (E) content of the present composition should be from 200 to 1,500 weight parts for each 100 weight parts of the sum of components (A) and (B). There is a tendency for the ultimately obtained cured silicone to have a reduced strength and an impaired repair behavior when the component (E) content is below the lower limit of the above-specified range. When the component (E) content exceeds the upper limit of the specified range, there is a tendency for such problems to appear as an inability to generate a uniform dispersion of component (E) in the curable silicone composition and an impaired flowability on the part of the curable silicone composition.

The curable silicone composition of this invention is prepared by mixing components (A) to (E), but may also contain optional components such as reaction inhibitors, pigments, dyes, fluorescent dyes, heat stabilizers, flame retardants, plasticizers, and adhesion promoters. The reaction inhibitors can be exemplified by acetylenic compounds, hydrazines, phosphines, and mercaptans.

The curable silicone composition of this invention can be cured by a hydrosilylation reaction to give a relatively low durometer elastomeric cured silicone with an excellent repair behavior comprising silicone rubber or silicone gel with a durometer, as measured by the type A durometer specified in JIS K 6253, of no more than 30 and preferably no more than 20. As a consequence of these features, this composition can be used as a sealant and potting agent for electrical and electronic components and as a coating for electric circuit boards and substrates.

The present curable silicone composition will now be explained in greater detail through the working examples that follow. The values reported for the physical properties of the cured silicones were measured at 25°C.

Four curable silicone compositions were prepared by mixing the components described below in the proportions reported in Table 1. The SiH/Vi value reported in Table 1 is the ratio of the number of moles of silicon-bonded hydrogen in the component corresponding to component (C) to the sum of the number of moles of vinyl in the components corresponding to components (A) and (B). Elastomeric cured silicone sheets with a thickness of 2 mm were fabricated by heating the curable silicone compositions for 30 minutes at 120°C using a hot press. The durometer of the cured silicones was measured using the type A durometer test described in JIS K 6253. The tensile strength and elongation were measured using the procedures specified in JIS K 6249 on the cured silicone sheet molded into #3 dumbbell shape. Durability testing of the tensile strength and elongation was carried out by preparing cured silicone sheet under the same conditions as above and testing this sheet by the same methods as above after the sheet had been heated at 100°C for 1,000 hours. The repair behavior of the cured silicone was investigated by placing the curable silicone composition on an aluminum plate; curing the composition by heating for 30 minutes at 120°C to give cured silicone with a thickness of 2 mm and a width of 10 mm; and subjecting this cured silicone to a 180° peel test at a peel rate of 300 mm/minute. To test the durability of the repair behavior, a test specimen was prepared by curing the curable silicone composition on an aluminum plate using the same conditions as above and was then tested as above after it had been heated at 100°C for 1,000 hours. The various test results are reported in Table 1.

### Description of components:

component (a-1): organopolysiloxane comprising 93.6 mole% (CH₃)₂SiO_{2/2} units, 2.5 mole% (CH₃)₃SiO_{1/2} units, 3 mole% CH₃SiO_{3/2} units, and 0.63 mole% (CH₃)₂(CH₂=CH)SiO_{1/2} units
component (a-2): organopolysiloxane constituted of 93.6 mole% (CH₃)₂SiO_{2/2} units, 1 mole% (CH₃)₃SiO_{1/2} units, 3 mole% CH₃SiO_{3/2} units, and 2.4 mole% (CH₃)₂(CH₂=CH)SiO_{1/2} units
component (b): dimethylvinylsiloxy-endblocked dimethylpolysiloxane with a viscosity of 900 mPa·s and a vinyl content of 0.23 weight%
component (c-1): dimethylhydrogensiloxy-endblocked dimethylpolysiloxane with a viscosity of 5 mPa·s and a silicon-bonded hydrogen content of 0.12 weight%
component (c-2): trimethylsiloxy-endblocked dimethylsiloxane-methylhydrogensiloxane copolymer with a viscosity of 20 mPa·s and a silicon-bonded hydrogen content of 0.76 weight%
component (d): a 1,3-divinyltetramethyldisiloxane solution of a 1,3-divinyltetramethyldisiloxane complex of platinum; the component (d) content in Table 1 is the weight (ppm) of platinum metal relative to the total weight of the components in the silicone composition corresponding to components (A) to (C)
component (e): alumina powder with an average particle size of 1.2 µm

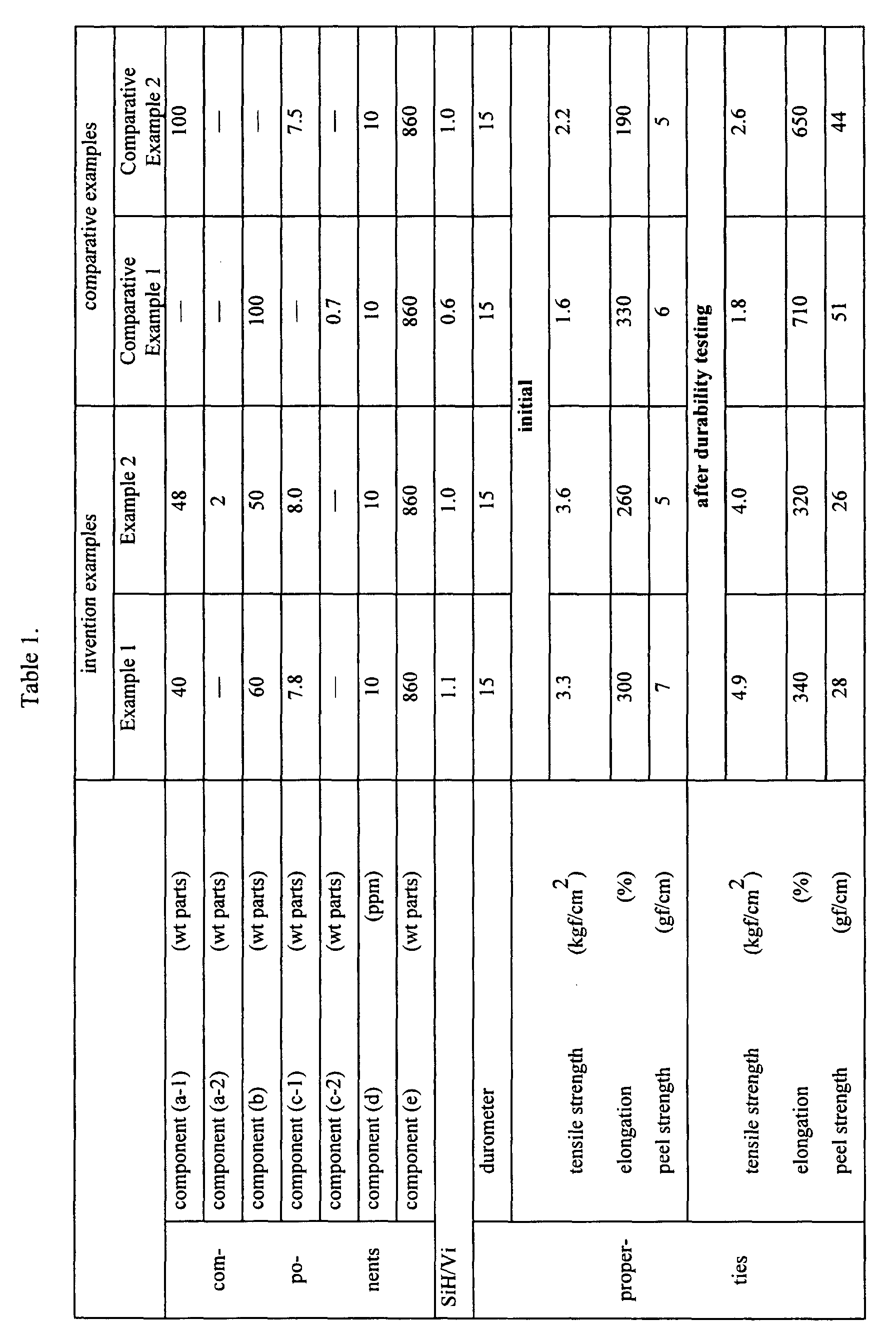

## Claims

1. A curable silicone composition comprising
(A) organopolysiloxane comprising 80 to 96.5 mole% R¹₂SiO_{2/2} units, 1 to 10 mole% R¹SiO_{3/2} units, 0 to 6 mole% R¹₃SiO_{1/2} units, and 0.25 to 4 mole% R¹₂R²SiO_{1/2} units where R¹ is a monovalent hydrocarbon group free of aliphatic unsaturation and R² is an alkenyl group;
(B) diorganopolysiloxane having a viscosity at 25°C of from 1 to 100,000 mPa·s and containing on average at least 2 alkenyl groups in each molecule, in a quantity such that component (B) is from 10 to 90 weight% of the sum of components (A) and (B);
(C) organopolysiloxane having a viscosity at 25°C of from 1 to 100,000 mPa·s and containing on average at least 2 silicon-bonded hydrogen atoms in each molecule, in a quantity that provides a value of 0.7 to 1.5 for the molar ratio of silicon-bonded hydrogen in this component to alkenyl groups in the sum of components (A) and (B);
(D) a platinum hydrosilylation catalyst in a quantity that provides from 0.01 to 1,000 weight parts platinum metal per million parts of the sum of components (A), (B), and (C);
and
(E) alumina powder at from 200 to 1,500 weight parts for each 100 weight parts of the sum of components (A) and (B).

2. A curable silicone composition according to Claim 1, where R² is vinyl.

3. A curable silicone composition according to Claim 1 or 2, where the alkenyl groups of component (B) are vinyl.

4. A curable silicone composition according to any of Claims 1 to 3, where component (C) has a viscosity of 1 to 5,000 mPa·s at 25°C.

5. A curable silicone composition according to any of Claims 1 to 4, where the alumina powder has a particle size ≤ 50 *µ*m.
